Europäisches Patentamt

(19) European Patent Office

Office européen des brevets

(11) Publication number : **0 303 633 B1**

(12) **EUROPEAN PATENT SPECIFICATION**

(45) Date of publication of patent specification :
15.07.92 Bulletin 92/29

(51) Int. Cl.⁵ : **G01R 31/36**

(21) Application number : **88900997.3**

(22) Date of filing : **23.12.87**

(86) International application number :
**PCT/US87/03472**

(87) International publication number :
**WO 88/04776 30.06.88 Gazette 88/14**

(54) **BATTERY MONITORING AND CONDITION INDICATOR SYSTEM FOR MULTI-BATTERY PACK.**

(30) Priority : **23.12.86 US 946769**

(43) Date of publication of application :
**22.02.89 Bulletin 89/08**

(45) Publication of the grant of the patent :
**15.07.92 Bulletin 92/29**

(84) Designated Contracting States :
**AT BE CH DE FR GB IT LI LU NL SE**

(56) References cited :
**EP-A- 0 080 164**
**DE-A- 2 842 817**
**US-A- 3 786 343**
**US-A- 4 198 597**
**US-A- 4 609 914**
**US-A-40 286 18**
**US-A-43 896 09**
**US-A-46 599 94**

(56) References cited :
**ENERGYGRAIN, Technical Information Center US, Department of Energy Oak Ridge Tennes- see, US; NO: DE 82007032; "Improvedtesting of multicell batteries"**
**P. Scargill, "Battery Condition Indicator", Practical Electronics, January 1978, pp. 330 & 331 See Figure 1**

(73) Proprietor : **WHITMIRE, Warren T.**
**3 Longwood Drive Box 983**
**Shalimar, FL 32579 (US)**
Proprietor : **ANDERSON, Larry T.**
**720 East Sunset Boulevard**
**Ft. Walton Beach, FL 32548 (US)**

(72) Inventor : **WHITMIRE, Warren T.**
**3 Longwood Drive Box 983**
**Shalimar, FL 32579 (US)**
Inventor : **ANDERSON, Larry T.**
**720 East Sunset Boulevard**
**Ft. Walton Beach, FL 32548 (US)**

(74) Representative : **Hofinger, Engelbert**
**Torggler-Hofinger Wilhelm-Greil-Strasse 16**
**A-6020 Innsbruck (AT)**

## Description

BACKGROUND OF THE INVENTION

The invention relates to a system for individually monitoring the condition of each battery and connecting cables in a multi-battery battery pack under load in order to provide a warning of possible battery pack failure, said system comprising:
means for detecting a voltage difference between two terminals of each of said batteries;
means responsive to said detecting means for indicating a battery condition for each of said batteries.

Power of work demands can be made upon battery power packs that have weak cells or batteries and/or high resistance cables without showing a noticeable loss in power output. This is especially true in devices that vary the voltage input to the load to control the speed or rate of work being done. This deficiency can go undetected and eventually cause a total failure of the battery pack. This type of failure can also occur in devices that apply the total pack output directly to the load. In any case, early detection of a power supply system defect will result in major savings in battery costs and as well as less down-time of equipment.

An example of a machine which is operated by a multi-battery pack is a typical electric golf cart. Such a golf cart may be powered by a battery pack comprising a series string of six-volt batteries of a type generally similar to an automobile battery. When the batteries are in a charged state and fully charged, each battery exhibits a voltage across its terminals of about 6.1 volts DC. This voltage drops slightly during peak loads. As the charge is gradually reduced in normal service, the terminal voltage tends to remain constant at about six volts, with a rapid drop towards zero as the battery becomes completely discharged.

Abnormally low terminal voltage of a battery or cell ordinarily indicates a very low charge condition, an extremely high level of loading or a defective cell. If one battery in a series of batteries, all of which have received the same maintenance and charge, has low terminal voltage, this is an indication of a faulty battery or a defective cable within the power supply system.

U.S. Patent No. 4,198,597 issued to Sawyer discloses a detector for sensing a defective cell among a plurality of voltage-producing cells which together form a source of DC electrical power. When a cell becomes defective causing its voltage output to drop, the voltage produced by the remaining cells create a load current by which the defective cell goes negative and forward biases the corresponding light-emitting diode which emits light and identifies the defective cell. Such a device, however, is not reliable in a situation where the light emitting diode is defective or there is a malfunction or problem with other portions of the circuitry. In such a situation, even though a battery may be defective, the corresponding light-emitting diode will not light up to indicate a defective cell.

EP-A-0 080 164 discloses a system which allows to monitor failures of specific batteries (reffered to as battery cells) of a multi-battery pack. The main idea is to detect the voltages across the individual battery cells and to compare the voltage of two adjacent battery cells, respectively. By comparing the voltages of individual battery cells to one another, it is then concluded that there must be a failure in a specific battery cell, if the voltage of this cell substantially differs from the voltages of the adjacent battery cell(s). This system might work properly to find out a failure of a battery cell, if only a single battery cells does not work appropriately. However, if several adjacent battery cells do not work correctly, it is in general impossible to locate all defective battery cells, as these defective cells might have the same low voltage and the system only responds to voltage differences between two battery cells, respectively. In the worst case, all battery cells fail in the same manner, and there being no voltage difference between the individual battery cells, there will be no failure indication at all. It might be true that such a real breakdown failure of all battery cells is not very probable, but, the system according to EP-A-0 080 164 also does not indicate a simple discharge condition of an intact battery, because with all battery cells at low voltage level there is no difference between the individual cells and it is just this difference that is measured. The device according to US-A-4 609 914 is essentially a voltage level indicator for a AC voltage line which monitors various voltage levels in a predetermined voltage range by a row of several visible LED's. This known device only monitors a single AC voltage line rather than a DC voltage of a battery, and there is no suggestion of individually monitoring battery cells of a battery-pack. With the known device, only when the outer two limits of a predetermined voltage range are exceeded is an audible alarm sounded that continues until manually reset.

The article "Battery Condition Indicator", by P.Scargill, in Practical Electronics, January 1978, pp 330-331, discloses the use of a pair of red and green LED's to monitor the voltage condition of a battery. However, this article deals with a single battery only and the LED's are not always on. Rather, one LED is on if the battery voltage is above a predetermined acceptable voltage range and the other LED is on if the battery voltage is below this voltage range. None of the LED's is on in the acceptable voltage range. Thus, the acceptable battery condition is not positively indicated. If both LED's are off, this could mean an acceptable working potential of the battery, but it could also be that the LED is broken and the monitoring system does not work at all. Thus no reliable information is given.

It is therefore a principal object of the present invention to provide a system for indicating the condition of each cell of a multi-battery battery pack and/or to isolate a defective cable connecting the batteries to the load.

A further object of the present invention is to provide a system for monitoring the condition of a plurality of batteries in a multi-battery battery pack which is simple in design, reliable and inexpensive to manufacture.

Still another object of the present invention is to provide a condition monitor for each battery in a multi-battery pack which is powered by the battery pack and "remembers" that condition after the load is removed even though the battery voltage rises after the load is removed.

## SUMMARY OF THE INVENTION

The battery condition monitoring system according to the invention is characterized in that for each of said batteries there is provided a battery condition indicating means being independent of every other battery condition indicating means and that each battery condition indicating means always indicates by means of one of two indicators, one of which is always activated, first of said indicators indicating a continuous acceptable working potential, second of said indicators indicating either a low working potential or an initial temporary drop in working potential by remaining activated until being manually reset by means for resetting said indicators.

In a normal condition, the system will provide an indication that the battery is operating under the proper voltage, and when the voltage of any one of the batteries deviates from the standard voltage, the system provides an indication that chat particular battery so deviates and "remembers" that condition even though the battery voltage returns to normal under a low or no load condition. The system utilizes a minimum amount of power, and the system is powered by the battery pack itself.

These and other objects and features of the present invention will be more fully understood from the following detailed description which should be read in light of the accompanying drawings in which corresponding reference numerals refer to corresponding parts throughout the several views. Also, in the drawings, several identical parts will be identified with reference numerals followed by a letter. In such a case, where the part is referred to solely by the numeral, any one of the identical parts may be reffered to for purposes of the description.

## BRIEF DESCRIPTION OF THE DRAWING

Fig. 1 is a plan view of an operation panel which can be connected to an indicator system of the present invention;

Fig. 2 is a schematic view of a system of the present invention designed for use with a six-battery battery pack;

Fig. 3 is a schematic diagram of the detecting and indicating circuitry of the system of the present invention which is designed for use with a six-battery battery pack;

Fig. 4 is a schematic diagram of the power supply circuitry of the system of the present invention which is designed for use with a six-battery battery pack; and,

Fig. 5 is a schematic diagram of the reset circuitry of the system of the present invention.

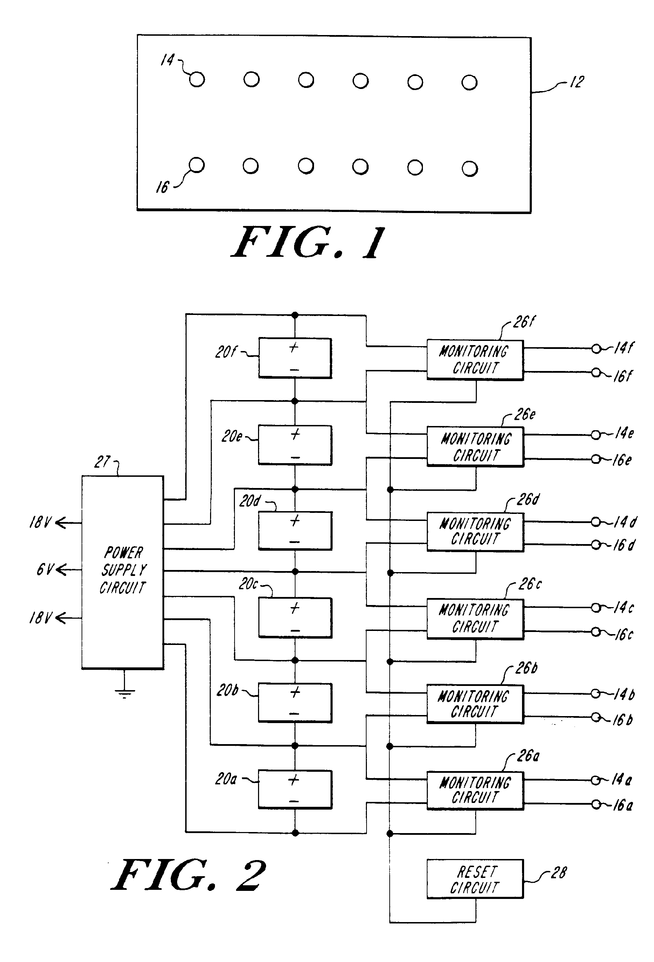

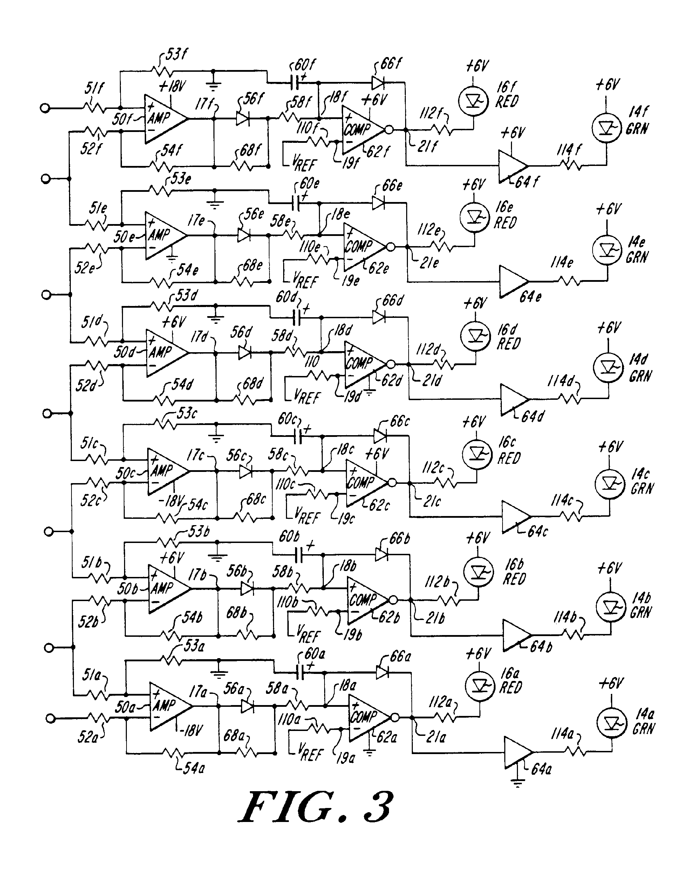

Appendix 1 is a listing of suitable, commercially available parts for the various electronic components shown in the Figs. 1-5.

## DETAILED DESCRIPTION OF THE PREFERRED EMBODIMENTS

The battery monitoring and condition indicator system of the present invention will be described with reference to a system which monitors and indicates the condition of six batteries in a six-battery battery pack. Referring to Fig. 1, a typical indicator panel 12 is shown which enables the system to provide a condition indication for each of the six batteries by lighting, in a preferred embodiment, a green light 14 for each battery operating at peak efficiency and a red light 16 for each weak battery. At all times, for each battery one of the lights 14 or 16 on the battery panel 12 will be lit indicating the status of the associated battery. In other words, either a green light 14 or a red light 16 will be lit for each battery in a battery pack.

Referring to Fig. 2, the batteries 20a, 20b, 20c, 20d, 20e and 20f are stacked in a series. The negative and positive terminals of each of the batteries are then connected to monitoring units 26a - 26f respectively as well as to a power supply circuit 27. Each of monitoring units 26a - 26f are in turn connected to a full power battery indicating device 14a - 14f respectively (in the preferred embodiment a green LED) and to a weak battery indicating device 16a - 16f respectively (in the preferred embodiment a red LED). A reset circuit 28 is also connected to each of the monitoring units 26a - 26f.

The monitoring circuits 26a - 26f are identical and independent. Each monitoring circuit 26a - 26f monitors a separate battery 20a - 20f in the six-battery battery stack. Using circuit 26d as an example the monitoring circuits will now be described in detail.

Operational amplifier 50d plus resistors 51d, 52d, 53d and 54d constitute a balanced DC amplifier. A suitable amplifier is a TL 082. Since the resistance of resistors 51d - 54d is equal, the gain is unity. A suitable value for resistors 51d - 54d is 22 K ohms. The grounding of resistor 53d causes the potential difference between resistors 51d and 52d to appear at junction 17d as a voltage referenced to circuit ground. This is necessary to allow the use of a common reference voltage thereby allowing for a common reset for all six monitoring circuits 26a - 26f.

The voltage at junction 17d is connected through diode 56d and resistor 58d and charges capacitor 60d. This voltage is connected to the positive input of the comparator 62d. The negative input of the comparator 62d is connected to the reference voltage. A suitable reference voltage is 4.4 volts. When the voltage across the battery 20d is equal to 6 volts the voltage at junction 17d will be 6 volts. The voltage at junction 18d will be approximately 5.4 volts due to the voltage drop across diode 56d. Since the 4.4 volts applied to junction 19d is lower than the voltage at junction 18d, the voltage at junction 21d will be positive and approximately equal to 6 volts.

This positive voltage will cause light emitting diode (LED) 16d to be turned off. This positive voltage is inverted by inverter 64d whose output is low or near ground potential. This causes the full power indicating device to be turned on by causing current to flow through the green LED 14d. Diode 66d has no effect in this condition since the cathode is at greater potential than the anode.

If the voltage across battery 20d drops below 5 volts, the voltage at junction 17d will also drop below 5 volts. The voltage at junction 18d will drop below 4.4 volts. This will cause the voltage at junction 18d to be less than the voltage at junction 19d, and the output of comparator 62d will be low or near ground potential. The weak battery indicating device will be turned on since current will flow through LED 16d. The output of inverter 64d will then be high or near 6 volts causing LED 14d to be turned off.

Since the anode of diode 66d is now higher than the cathode by at least .6 volts the diode 66d will conduct and pull junction 18d down to approximately 1 volt. This has the effect of latching the circuit in the low voltage state. If the voltage across the battery 20d rises above 5 volts, diode 66d will prevent the voltage at junction 18d from rising. The circuit may be reset by switch 67 which momentarily lowers the reference voltage to 0 volts. This causes the voltage at junction 18d to be higher than the voltage at junction 19d. The output of comparator 62d will then be high and diode 66d will cease to conduct.

Resistor 68d and capacitor 60d provide a time constant that prevents noise in the circuit voltage, such as that caused by starting a motor, from being detected as a fault. Diode 56d bypasses resistor 68d for faster response to voltage increases since without diode 56d repeated short voltage drops might discharge capacitor 60d which would cause a fault indication.

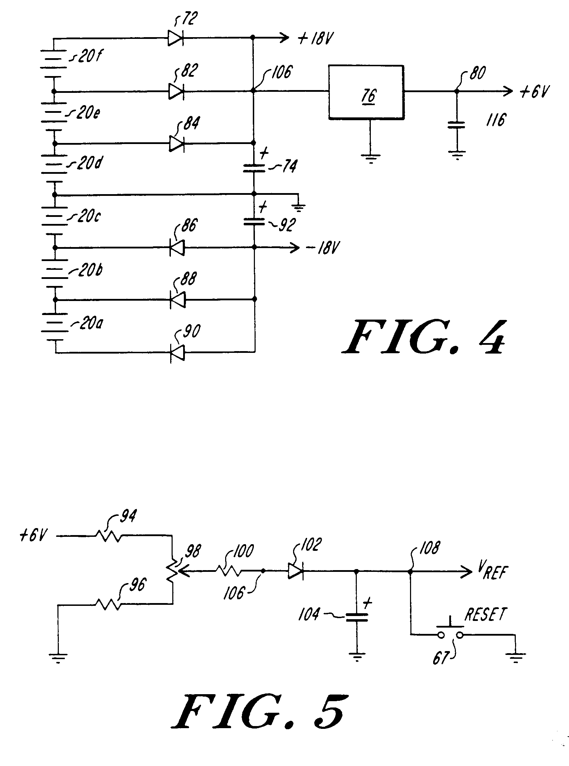

The power supply circuitry of a preferred embodiment is shown in detail in Fig. 4. Diode 72 and capacitor 74 provide +18 volts to voltage regulator 76 which provides a regulated +6 volts at junction 80. This regulation is necessary to prevent noise from the external load (motors, relays, etc.) from false triggering the comparators and causing fault indication. +18 volts is also supplied to amplifiers 50f and 50e. Diodes 82 and 84 are necessary to supply voltage to regulator 76 in the event battery 20e or battery 20f and battery 20e fail. Diodes 86, 88 and 90 and capacitor 92 supply -18 volts for amplifiers 50a and 50b.

The reset circuitry of a preferred embodiment is shown in Fig. 5. Resistors 94, 96, 98 and 100, diode 102 and capacitor 104 supply the reference voltage to the comparators 62a - 62f. Diode 102 is provided to compensate for the diodes 56a - 56f connected to the outputs of the operational amplifiers 50a - 50f. This reference voltage may be set by adjusting resistor 98 while monitoring junction 106 for the desired voltage. The desired reference voltage in a preferred embodiment is approximately 4.4 volts at junction 108.

Amplifiers 50f and 50e are powered from +18 volts and ground since the input voltages to these amplifiers range from +6 to +18 volts with respect to system ground. Amplifiers 50c and 50d are powered from +6 and -18 volts since the input voltages to these amplifiers range from -6 to +6 volts with respect to system ground. Amplifiers 50a and 50b are powered from +6 and -18 volts since the input voltages to these amplifiers range from -18 to -6 volts with respect to system ground. This is necessary to prevent the inputs from exceeding the power supply voltages connected to the amplifiers. The comparators 62a - 62f are powered from +6 volts and system ground since their inputs only see 0 to +6 volts.

While the foregoing invention has been described with reference to its preferred embodiments, various modifications and alterations will occur to those skilled in the art. For example, while the system of the present invention has been described with reference to six batteries, such a system can of course be manufactured to accommodate any number of batteries in a series or cells in one battery application or parallel series applications of batteries. In addition, the entire circuit package with the exception of the LEDs might be integrated into a monolithic circuit element (integrated circuit) to simplify production and reduce costs.

<u>APPENDIX I</u>

| | | |
|---|---|---|
| Resistors 52, 52, 53 54, 58, 110 | 22 K ohms | (6 places) |
| Resistor 68 | 1 M ohms | (6 places) |
| Resistors 112, 114 | 1 K ohms | (6 places) |
| Resistor 100 | 1 K ohms | (6 places) |
| Resistor 94 | 820 ohms | (6 places) |
| Resistor 96 | 1.8 K ohms | (6 places) |
| Resistor 98 | 10 K ohms | (6 places) |
| Amplifier 50 | TL 082 | (3 used) |
| Comparator 62 | LM 339 | (2 used) |
| Inverter 64 | CD 4049 | |
| LEDs 14,16 | 35BL505/6 | (6 places) |
| Diodes 56, 66 | 1N4148 | |
| Diodes 102 | 1N4148 | |
| Regulator 76 | 7806 | |
| Capacitor 60 | 1.0 mfd | (6 places) |
| Capacitors 92, 74 | 100 mfd | |
| Capacitor 116 | 0.1 mfd | |
| Capacitor 104 | 10 mfd | |

**Claims**

1. A system for individually monitoring the condition of each battery (20a-20f) and connecting cables in a multi-battery battery pack under load in order to provide a warning of possible battery pack failure, said system comprising:
means (50a-50f) for detecting a voltage difference between two terminals of each of said batteries (20a-20f);
means (62a-62f, 14a-14f, 16a-16f) responsive to said detecting means (50a-50f) for indicating a battery condition for each of said batteries (20a-20f),
characterized in that for each of said batteries (20a-20f) there is provided a battery condition indicating means (62a-62f, 14a-14f, 16a-16f) being independent of every other battery condition indicating means (62a-62f, 14a-14f, 16a-16f), and that each battery condition indicating means (62a-62f, 14a-14f, 16a-16f) always indicates by moans of one of two indicators (14a-14f, 16a-16f), one of which is always activated, first (14a-14f) of said indicators indicating a continuous acceptable working potential, second (16a-16f) of said indicators indicating either a low working potential or an initial temporary drop in working potential by remaining activated until being manually reset by means (28) for resetting said indicators (16a-16f).

2. The battery condition monitoring system of claim 1 wherein each of said first indicators (14a-14f) is a first color light, preferably green light emitting diode and that each of said second indicators (16a-16f) is a second color light, preferably red light emitting diode.

3. The battery condition monitoring system of claim 1 wherein said detecting means comprises an operational amplifier (50a-50f) connected as a unity gain non-inverting amplifier across an individual battery (20a-20f), said amplifier (50a-50f) being connected to the the positive terminal of a voltage comparator (62a-62f), said comparator (62a-62f) having a positive reference voltage ($V_{REF}$) connected to its negative terminal; said comparator (62a-62f) providing a first output which is a positive voltage signal when the battery (20a-20f) is greater than the reference voltage and a second output which is substantially zero volts when the battery voltage is lower than the reference voltage.

4. The battery condition monitoring system of claim 2 or 3, wherein said first color light emitting diode (14a-14f) is capable of being driven by said first output and said second color light emitting diode (16a-16f) is capable of being driven by said second output.

5. The battery condition monitoring system of claim 3 or 4, characterized by means (66a-66f) for storing said first and second output with said second output being permanently stored until manually reset.

6. The battery condition monitoring system according to any claim of claims 3 - 5, characterized in that said amplifier (50a-50f) has a feedback resistor (53a-53d) connected to ground in order to allow the use of a common reference voltage ($V_{REF}$) and a common means (28) for resetting all of said battery condition indication means, and that said means (28) for resetting all of said battery condition indicating means includes a means (67) for momentarily lowering the reference voltage ($V_{REF}$) to zero volts.

7. The battery condition monitoring system according to any claim of claims 1-6, further comprising a means (60a-60f, 68a-68f; 76) for eliminating false alarms caused by external loads.

## Patentansprüche

1. System zur einzelnen Überwachung des Zustandes jeder Batterie (20a-20f) und der Verbindungskabel in einer Mehrfachbatterieeinheit unter Belastung, um eine Warnung im Hinblick auf einen Fehler der Batterieeinheit zu geben, wobei das System umfaßt:
eine Einrichtung (50a-50f) zur Erfassung einer Spannungsdifferenz zwischen den beiden Anschlüssen jeder der genannten Batterien (20a-20f);
eine Einrichtung (62a-62f, 14a-14f, 16a-16f), die auf diese Erfassungseinrichtung (50a-50f) zur An zeige eines Batteriezustandes für jede der genannten Batterien (20a-20f) anspricht,
dadurch gekennzeichnet, daß für jede der genannten Batterien eine Batteriezustandsanzeigeeinrichtung (62a-62f, 14a-14f, 16a-16f) vorgesehen ist, die unabhängig von jeder anderen Batteriezustandsanzeigeeinrichtung (62a-62f, 14a-14f, 16a-16f) ist, und daß jede Batteriezustandsanzeigeeinrichtung (62a-62f, 14a-14f, 16a-16f) immer mit einem von zwei Anzeigern (14a-14f, 16a-16f) eine Anzeige liefert, wobei einer dieser Anzeiger immer aktiviert ist, wobei der erste (14a-14f) dieser Anzeiger ein durchwegs akzeptables Arbeitspotential anzeigt und der zweite (16a-16f) dieser Anzeiger entweder ein so niedriges Arbeitspotential oder einen anfänglichen zeitweisen Abfall im Arbeitspo tential anzeigt, indem er aktiviert bleibt, bis er mittels einer Rücksetzeinrichtung (28) für diese Anzeiger (16a-16f) händisch zurückgesetzt wird.

2. Batteriezustandsüberwachungssystem nach Anspruch 1, worin jeder der genannten ersten Anzeiger (14a-14f) eine Leuchtdiode ist, die ein erstes farbiges Licht, vorzugsweise grün, emittiert, und daß jeder der genannten zweiten Anzeiger (16a-16f) eine Leuchtdiode ist, die Licht einer zweiten Farbe, vorzugsweise rot, emittiert.

3. Batteriezustandsüberwachungssystem nach Anspruch 1, worin die genannte Erfassungseinrichtung einen Operationsverstärker (50a-50f) umfaßt, der als nicht-invertierender Verstärker mit Verstärkung eins über eine einzelne Batterie (20a-20f) angeschlossen ist, wobei dieser Verstärker (50a-50f) an den positiven Eingang eines Spannungskomparators (62a-62f) angeschlossen ist, welcher eine positive Referenzspannung ($V_{ref}$) an seinen negativen Eingang angeschlossen hat, wobei der genannte Komparator (62a-62f) eine erste Ausgabe liefert, die ein positives Spannungssignal ist, wenn die Batteriespannung größer ist als die Referenzspannung, und der eine zweite Ausgabe liefert, die im wesentlichen null Volt beträgt, wenn die Batteriespannung geringer ist als die Referenzspannung.

4. Batteriezustandsüberwachungssystem nach Anspruch 2 oder 3, worin die genannte Licht emittierende Diode der ersten Farbe (14a-14f) fähig ist, von dieser ersten Ausgabe angesteuert zu werden und wobei die Licht emittierende Diode der zweiten Farbe (16a-16f) fähig ist, von der genannten zweiten Ausgabe angesteuert zu werden.

5. Batteriezustandsüberwachungssystem nach Anspruch 3 oder 4, gekennzeichnet durch eine Einrichtung (66a-66f) zum Speichern der genannten ersten und zweiten Ausgabe, wobei die genannte zweite Ausgabe dauernd gespeichert wird, bis sie händisch zurückgesetzt wird.

6. Batteriezustandsüberwachungssystem nach einem der Ansprüche 3 bis 5, dadurch gekennzeichnet, daß der genannte Verstärker (50a-50f) einen Rückkopplungswiderstand (53a-53d) aufweist, der an Masse angeschlossen ist, um die Verwendung einer gemeinsamen Referenzspannung (V$_{ref}$) und einer gemeinsamen Einrichtung (28) zum Zurücksetzen aller der genannten Batteriezustandsanzeigeeinrichtungen zu erlauben, und daß die genannten Einrichtungen (28) zum Zurücksetzen aller der genannten Batteriezustandsanzeigeeinrichtungen eine Einrichtung (67) umfaßt, um die Referenzspannung (V$_{ref}$) momentan auf null Volt abzusenken.

7. Batteriezustandsüberwachungssystem gemäß einem der Ansprüche 1 bis 6, welches weiter eine Einrichtung (60a-60f, 68a-68f, 76) umfaßt, um durch externe Lasten hervorgerufene falsche Alarme zu eliminieren.

**Revendications**

1. Système de contrôle individuel de l'état de chaque batterie (20a-20f) et des câbles de connexion d'un ensemble de batteries sous charge aux fins de fournir un avertissement en cas de défaillance possible de l'ensemble de batteries, ledit système comprenant :
des moyens (50a-50f) de détection d'une différence de tension entre deux bornes de chacune desdites batteries (20a-20f) ;
des moyens (62a-62f ; 14a-14f ; 16a-16f) adaptés à répondre auxdits moyens de détection (50a-50f) pour indiquer un état de batterie pour chacune desdites batteries (20a-20f) ;
caractérisé en ce que pour chacune desdites batteries (20a-20f) est prévu un moyen indicateur d'état de batterie (62a-62f ; 14a-14f ; 16a-16f) indépendant de tous les autres moyens indicateurs d'état de batterie (62a-62f ; 14a-14f ; 16a-16f) et en ce que chaque moyen indicateur d'état de batterie (62a-62f ; 14a-14f ; 16a-16f) donne toujours une indication au moyen de l'un de deux indicateurs (14a-14f ; 16a-16f), dont l'un est toujours activé, le premier (14a-14f) desdits indicateurs indiquant un potentiel de travail acceptable continu, le second (16a-16f) desdits indicateurs indiquant soit un faible potentiel de travail, ou soit une chute temporaire initiale du potentiel de travail, en restant activé jusqu'à ce qu'il soit remis à l'état initial par des moyens (28) de remise à l'état initial desdits indicateurs (16a-16f).

2. Système de contrôle de l'état de batterie selon la revendication 1, dans lequel chacun desdits premiers indicateurs (14a-14f) est une première lumière colorée, de préférence une diode émettrice de lumière verte, et en ce que chacun desdits seconds indicateurs (16a-16f) est une seconde lumière colorée, de préférence une diode émettrice de lumière rouge.

3. Système de contrôle de l'état de batterie selon la revendication 1, dans lequel chacun des moyens détecteurs comprend un amplificateur opérationnel (50a-50f) connecté, sous la forme d'un amplificateur non inversant dont le gain est l'unité, d'un côté à l'autre d'une batterie individuelle (20a-20f), ledit amplificateur (50a-50f) étant connecté à la borne positive d'un comparateur de tension (62a-62f), ledit comparateur (62a-62f) ayant une tension de référence positive (V$_{REF}$) connectée à sa borne négative ; ledit comparateur (62a-62f) donnant une première sortie qui est un signal de tension positive lorsque la tension de la batterie (20a-20f) est supérieure à la tension de référence, et une seconde sortie qui est sensiblement de 0 volt lorsque la tension de la batterie est inférieure à la tension de référence.

4. Système de contrôle de l'état de batterie selon la revendication 2 ou 3, dans lequel ladite première diode émettrice de lumière colorée (14a-14f) est capable d'être actionnée par ladite première sortie et ladite seconde diode émettrice de lumière colorée (16a-16f) est capable d'être actionnée par ladite seconde sortie.

5. Système de contrôle de l'état de batterie selon la revendication 3 ou 4, caractérisé par des moyens (66a-66f) de stockage desdites première et seconde sorties, ladite seconde sortie étant stockée en permanence jusqu'à remise à l'état initial manuelle.

6. Système de contrôle de l'état de batterie selon l'une quelconque des revendications 3 à 5, caractérisé en ce que ledit amplificateur (50a-50f) a une résistance (53a-53d) à contre-réaction réunie à la terre pour permettre l'utilisation d'une tension de référence commune (V$_{REF}$) et un moyen commun (28) pour remettre à l'état initial tous les moyens indicateurs d'état de batterie, et en ce que lesdits moyens (28) de remise à l'état initial de tous les moyens indicateurs d'état de batterie, comprennent un moyen (67) pour abaisser temporairement la tension de référence (V$_{REF}$) à 0 volt.

7. Système de contrôle de l'état de batterie selon l'une quelconque des revendications 1 à 6, comprenant en outre un moyen (60a-60f ; 68a-68f ; 76) pour éliminer les fausses alarmes provoquées par des charges extérieures.

*FIG. 1*

*FIG. 2*

# FIG. 3

FIG. 4

FIG. 5